# EUROPEAN PATENT SPECIFICATION

(11) **EP 1 900 681 B1**
(45) Date of publication and mention of the grant of the patent: **15.03.2017**
(21) Application number: 06024507.3
(22) Date of filing: 27.11.2006
(51) Int. Cl.: H01L 29/739, H01L 29/06, B82Y 10/00, B82B 1/00, H01L 29/10

(54) **Tunnel Field-Effect Transistors based on silicon nanowires**
Tunnelfeldeffekttransistoren auf der Basis von Siliziumnanodrähte
Transistors à effet de champ et effet tunnel à base de nanofils de silicium

(30) Priority: 15.09.2006 US 845006 P
(43) Date of publication of application: 19.03.2008
(73) Proprietor: IMEC, 3001 Leuven (BE); Katholieke Universiteit Leuven, 3000 Leuven (BE)
(72) Inventor: Verhulst, Anne, S., 2234 Houtvenne (BE)
(74) Representative: DenK iP

(56) References cited:
- EP-A1- 1 643 560
- WO-A-02/084757
- WO-A-2006/073477
- US-A1- 2002 163 079
- US-A1- 2002 172 820
- US-A1- 2004 075 464
- LIN C-P ET AL: "Process and Characteristics of Modified Schottky Barrier (MSB) p-Channel FinFETs" IEEE TRANSACTIONS ON ELECTRON DEVICES, IEEE SERVICE CENTER, PISACATAWAY, NJ, US, vol. 52, no. 11, November 2005 (2005-11), pages 2455-2462, XP011141557 ISSN: 0018-9383
- BJÖRK M T ET AL: "One-dimensional heterostructures in semiconductor nanowhiskers" APPLIED PHYSICS LETTERS, AIP, AMERICAN INSTITUTE OF PHYSICS, MELVILLE, NY, US, vol. 80, no. 6, 11 February 2002 (2002-02-11), pages 1058-1060, XP012031509 ISSN: 0003-6951
- BHUWALKA K K ET AL: "A Simulation Approach to Optimize the Electrical Parameters of a Vertical Tunnel FET", IEEE TRANSACTIONS ON ELECTRON DEVICES, IEEE SERVICE CENTER, PISACATAWAY, NJ, US, vol. 52, no. 7, 1 July 2005 (2005-07-01), pages 1541-1547, XP011135503, ISSN: 0018-9383, DOI: 10.1109/TED.2005.850618
- KRISHNA KUMAR BHUWALKA ET AL: "VERTICAL TUNNEL FIELD-EFFECT TRANSISTOR", IEEE TRANSACTIONS ON ELECTRON DEVICES, IEEE SERVICE CENTER, PISACATAWAY, NJ, US, vol. 51, no. 2, 1 February 2004 (2004-02-01), pages 279-282, XP001186093, ISSN: 0018-9383, DOI: 10.1109/TED.2003.821575

## Description

### FIELD OF THE INVENTION

The present invention is related to the field of semiconductor devices and nanotechnology. More specifically, the invention is related to a nanostructure semiconductor device, more specifically to a tunnel field effect transistor having a heterostructure nanowire, and a method for manufacturing such tunnel field effect transistor devices with integrated nanowires.

### BACKGROUND OF THE INVENTION

Microelectronic devices are generally fabricated on semiconductor substrates as integrated circuits. A complementary metal-oxide-semiconductor (CMOS) field effect transistor is one of the core elements of the integrated circuits. Dimensions and operating voltages of CMOS transistors are continuously reduced, or scaled down, to obtain ever-higher performance and packaging density of the integrated circuits.

One of the problems due to the scaling down of CMOS transistors, is that the power consumption keeps increasing. This is partly because leakage currents are increasing (e.g. due to short channel effects) and because it becomes difficult to decrease the supply voltage. The latter is mainly due to the fact that the subthreshold slope is limited to minimally about 60 mV/decade, such that switching the transistor from ON to OFF needs a certain voltage variation and therefore a minimum supply voltage.

Tunnel field-effect transistors (TFETs) are typically advertised as successors of metal-oxide semiconductor field-effect transistors (MOSFETs), because of their absence of short-channel effects and because of their resulting low off-currents. Another advantage of TFETs is that the subthreshold slope can be less than 60 mV/dec, the physical limit of conventional MOSFETs, such that potentially lower supply voltages can be used. However, TFETs typically suffer from low on-currents, a drawback related to the large resistance of the tunnel barrier.

In US 2005/0274992, a method of fabricating an improved TFET using nanowires is disclosed. The method comprises forming in a nanotube (i.e. a nanowire without axial opening) an n-doped region and a p-doped region that are separated by an undoped channel region of the transistor. Electrical contacts are provided for the doped regions and a gate electrode that is formed upon a gate dielectric layer is deposited on the channel region of the transistor. The proposed structure still has the disadvantage of introducing new materials (carbon nanotubes).

To increase the on-current of a silicon TFET, suggestions have been made in literature by Bhuwalka et al. (IEEE transactions on electron devices Vol 52, No 7, July 2005) to add a small (about 3 nm wide) section of highly-doped Si₁₋ₓGeₓ at the tunnel barrier. The Si₁₋ₓGeₓ has a smaller band gap than Si such that the tunnel barrier width decreases due to the presence of this section. However, these structures with the Si₁₋ₓGeₓ section, can still not compete with conventional MOSFETs because of their low on-currents.

Further devices using nanowires as active transistor elements are known from WO2006/073477 and US2004/0075464.

As a conclusion, there is still a need for an improved method of fabricating a nanowire tunnel field effect transistor.

### SUMMARY OF THE INVENTION

It is an object of the present invention to provide semiconductor device structures with an improved architecture and having low power consumption using nanostructures such as nanowires and to the method for the manufacturing of such semiconductor device structures.

The invention is defined by a device according to claim 1 and a method according to claim 23. The creation of a tunnel field effect transistor having at least one nanowire (further referred to as a NW-TFET), said nanowire comprising the channel region, source/drain regions and a heterosection is disclosed. Said heterosection is situated in between the channel region and one of the source/drain regions.

It is further an advantage of the NW-TFET of the present invention that Si based materials and process knowledge can be used to create the NW-TFET such that the NW-TFET can be easily processed and incorporated in current Si-based technology devices.

Embodiments of the invention relate to micro and nanoelectronics and are preferably but not always, used for developing low power semiconductor device structures. Using the tunnel field effect transistor of the invention it is possible to increase the number of transistors on a chip further. The nanowire tunnel field effect transistor of some embodiments of the invention can be based on current Si based technology and can therefore be easily incorporated in current devices using current state of the art technologies. The nanowire tunnel field effect transistor of some of the embodiments is distinguished from all analogous TFETs known in prior art by the integration of an appropriate heterosection. A heterosection is a section along the longitudinal axis of a nanowire which is made of a material which is different from the material of the main part of the nanowire. The heterosection can help enable an improved performance in terms of any or all of: high ON currents (the resistance associated with the tunnel barrier can be decreased by using a material with a very small bandgap for the heterosection), low OFF currents (the off-current is determined by the material of the main part of the nanowire, and can be chosen independently of the material of the heterosection) and fast OFF-to-ON transition (as simulations have indicated, in the presence of a heterosection, whereby the heterosection material has a smaller bandgap than the material of the main part of the nanowire, the OFF-to-ON transition becomes faster). The interface between the material of the main part of the nanowire and the heterosection can be substantially defect-free, i.e. it does not result in a highly defective interface, because this is a nanowire and the very small cross section allows for efficient lateral stress relaxation. An example is a silicon nanowire with a germanium heterosection, where the lattice mismatch between silicon and germanium does not result in a highly defective interface.

In a preferred embodiment of the invention, a Tunnel Field Effect Transistor (TFET) semiconductor device is disclosed. Said TFET comprises at least one nanowire (to form a NW-TFET), said nanowire further comprising at least one source region made of a first semiconductor material which is highly doped according to a first conductivity type, e.g. p doped (or n doped), at least one drain region made of a first semiconductor material which is highly doped according to a second conductivity type, e.g. n doped (or p doped), at least one channel region made of a first semiconductor material which is lowly doped according to the second conductivity type, e.g. n doped (or p doped), and which is situated in between the source and drain region and a heterosection made of a second semiconductor material which is highly doped and which is situated in between the source region (or drain region) and the channel region.

In an alternative embodiment and also preferred, said heterosection can be made of a metal such as Al, W, Ta, Ti, Ru, Pd, Rh, Re, Pt, and alloys thereof, a silicide, a germanide, a metal-nitride such as TaN and TiN, a conductive oxide such as RuO₂ and ReO₂, a silicided metal such as CoSi₂, NiSi₂, a metal germanide and/or alloys and mixtures thereof.

The Tunnel Field Effect Transistor (NW-TFET) further comprises a gate structure, said gate structure preferably made of a gate dielectric, e.g. gate oxide, situated onto the channel region of the NW-TFET and a gate contact situated on top of the gate dielectric, e.g. gate oxide. The gate dielectric is preferably selected from at least one of silicon based oxide (e.g. silicon dioxide, silicon oxy nitride) aluminium oxide, high-k oxides (oxides, nitrided oxides), silicates and nitrided silicates of transition metals such as Hf, Ta, Ti, Nb, V, Y, Zr. Most preferred the gate oxide is a high-k oxide such as hafnium oxide. The thickness of the gate dielectric is preferably in the range of 0.5 nm to 20 nm. The gate contact is preferably made of a conductive material and is selected from at least one of poly silicon, poly germanium, metals such as Al, W, Ta, Ti, Ru, Pd, Rh, Re, Pt, and alloys thereof, metal-nitrides such as TaN and TiN, metal-silicon nitrides such as TaSiN, conductive oxides such as RuO₂ and ReO₃, fully silicided metals (FUSI) such as CoSi₂, NiSi and TiSi₂, fully germanided metals (FUGE). The gate contact is chosen such that a particular gate workfunction is obtained specifically for the chosen nanowire material (first and second semiconductor material), gate dielectric and gate dielectric thickness. Most preferred the gate structure (containing the gate contact and gate dielectric) of the NW-TFET covers completely the channel region of the nanowire.

The Tunnel Field Effect Transistor (NW-TFET) of some embodiments of the present invention further comprises an electrical contact on each of the source region and drain region. Preferably the electrical contact on each of the source region and drain region is a conductive material which is selected from at least one of a silicide containing structure (NiSi, CoSi₂, TiSi₂, ...), a germanide containing structure, a metal containing structure, poly silicon or a combination thereof. More preferred is that said electrical contact on each of the source region and drain region is a combination of a metal with a silicide.

The first semiconductor material in the NW-TFET of the present invention is preferably selected from at least one of group IV materials such as Si, Ge, C and binary compounds thereof, or group III/V materials such as In, Ga, As, Sb, Al, P, B, N and binary, tertiary and quaternary compounds thereof or group II/VI materials such as Cd, Zn, S, Se, Te, O and binary, tertiary and quaternary compounds thereof. Most preferred is that the first semiconductor material in NW-TFET of the present invention is silicon.

The second semiconductor material in the NW-TFET of the present invention is preferably made of a material that has a different lattice constant from the first semiconductor material of the NW-TFET. Preferably said second semiconductor material is selected from at least one of group IV materials such as Si, Ge, C and binary compounds thereof, or group III/V materials such as In, Ga, As, Sb, Al, P, B, N and binary, tertiary and quaternary compounds thereof or group II/VI materials such as Cd, Zn, S, Se, Te, O and binary, tertiary and quaternary compounds thereof. Most preferred the second semiconductor material in NW-TFET of the present invention is germanium or Si₁₋ₓGeₓ with x>0.5.

The diameter of the NW, perpendicular to its longitudinal axis, used in the NW-TFET of some embodiments of the present invention is between 2 and 200 nm.

The length of the NW, along its longitudinal axis used in the NW-TFET of some embodiments of the present invention is preferably in the range of 5 nm and 2 µm, more preferred the length of the NW used in the NW-TFET of the present invention is between 10 nm and 1 µm.

The length of the heterosection in the NW-TFET of some embodiments of the present invention is preferably in the range of 1 nm and 50 nm, more preferred the length of the heterosection in the NW-TFET of the present invention is between 2 nm and 10 nm.

The length of the channel region in the NW-TFET of some embodiments of the present invention is preferably in the range of 1 nm and 1000 nm, more preferred the length of the channel region in the NW-TFET of the present invention is between 1 nm and 100 nm.

The doping level of the source region and drain region in the NW-TFET of some embodiments of the present invention is preferably in the range of 10¹⁸/cc to 10²¹/cm, more preferred the doping level of the source region and drain region in the NW-TFET is in the range of 10¹⁹/cc to 5x10²⁰/cc.

The doping level of the heterosection in the NW-TFET of the present invention is preferably in the range of 10¹⁸/cc to 10²¹/cc, more preferred the doping level of the heterosection in the NW-TFET is in the range of 10¹⁹/cc to 5x10²⁰/cc.

The doping level of the channel region in the NW-TFET of the present invention is preferably in the range of undoped up to 5x10¹⁴/cc.

Furthermore the invention concerns a method for manufacturing a NW-TFET semiconductor device according to claim 23.

Further steps of some embodiments of the method can involve one or more of:
- depositing on the side walls of the nanowire a gate dielectric, e.g. gate oxide,
- depositing on top of the gate dielectric a gate contact, and
- forming a drain contact on top of the drain region of the nanowire.

In a preferred embodiment, the substrate used for manufacturing a NW-TFET is a Si wafer.

In a preferred embodiment, said first semiconductor material is selected from at least one of group IV materials such as Si, Ge, C and binary compounds thereof, or group III/V materials such as In, Ga, As, Sb, Al, P, B, N and binary, tertiary and quaternary compounds thereof or group II/VI materials such as Cd, Zn, S, Se, Te, O and binary, tertiary and quaternary compounds thereof and most preferred said first semiconductor material is silicon.

In a preferred embodiment, said heterosection is made of a second semiconductor material, whereby said second semiconductor material is such that it has a different lattice constant from the first semiconductor material of the nanowire.

In a preferred embodiment, said second semiconductor material is selected from at least one of the group IV materials such as Si, Ge, C and binary compounds thereof, or group III/V materials such as In, Ga, As, Sb, Al, P, B, N and binary, tertiary and quaternary compounds thereof or group II/VI materials such as Cd, Zn, S, Se, Te, O and binary, tertiary and quaternary compounds thereof and most preferred said second semiconductor material is germanium or Si₁₋ₓGeₓ with x>0.5.

Alternatively and also preferred, said heterosection can be made of metals (Al, W, Ta, Ti, Ru, Pd, Rh, Re, Pt, and alloys thereof), silicides, germanides, metal-nitrides such as TaN and TiN, conductive oxides such as RuO₂ and ReO₂, silicided metals such as CoSi₂, NiSi₂, metal germanides and alloys and mixtures thereof.

In a preferred embodiment the diameter of the nanowire is between 2 and 200 nm.

In a preferred embodiment the length of the nanowire is between 5 nm and 2 µm. More preferred the length of the nanowire is between 10 nm and 1 µm.

In a preferred embodiment the gate dielectric is selected from at least one of silicon based oxide (e.g. silicon dioxide, silicon oxy nitride) aluminium oxide, high-k oxides (oxides, nitrided oxides), silicates and nitrided silicates of transition metals such as Hf, Ta, Ti, Nb, V, Y, Zr. More preferred the gate oxide is a high-k oxide such as hafnium oxide.

In a preferred embodiment the gate contact is made of a conductive material and is selected from at least one of poly silicon, poly germanium, metals such as Al, W, Ta, Ti, Ru, Pd, Rh, Re, Pt, and alloys thereof, metal-nitrides such as TaN and TiN, metal-silicon nitrides such as TaSiN, conductive oxides such as RuO₂ and ReO₃, fully silicided metals (FUSI) such as CoSi₂, NiSi and TiSi₂, fully germanided metals (FUGE), workfunction tunable metals, engineered materials to obtain a particular gate workfunction. More preferred the gate contact is made of a metal of which the workfunction has been engineered specifically for the chosen nanowire material (first and second semiconductor material).

In a preferred embodiment the source and drain are made from a conductive material which is selected from at least one of a silicide containing structure (NiSi, CoSi₂, TiSi₂, ...), a germanide containing structure, a metal containing structure, poly silicon or a combination thereof. More preferred said source and drain is a combination of a metal with a silicide.

In a preferred embodiment the length of said heterosection is in the range of 1 nm up to 50 nm. More preferred the length of said heterosection is in the range of 2 nm to 10 nm.

In a preferred embodiment the length of said channel region is in the range of 1 nm to 1000 nm. More preferred the length of said channel region is in the range of 1 nm to 100 nm.

In a preferred embodiment the thickness of the gate dielectric is in the range of 0.5 nm to 20 nm.

In a preferred embodiment the doping level of the source region and drain region is in the range of 10¹⁸/cc to 10²¹/cc. More preferred the the doping level of the source region and drain region is in the range of 10¹⁹/cc to 5x10²⁰/cc.

In a preferred embodiment the doping level of the heterosection is in the range of 10¹⁸/cc to 10²¹/cc. More preferred the doping level of the heterosection is in the range of 10¹⁹/cc to 5x10²⁰/cc.

In a preferred embodiment the doping level of the channel region is in in the range of undoped up to 10¹⁴/cc doping.

For the application in tunnel field-effect-transistor (TFET) devices said nanowire forms the channel and source/drain regions of the tunnel field-effect transistor.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

### BRIEF DESCRIPTION OF THE DRAWINGS

Exemplary embodiments are illustrated in referenced figures of the drawings. It is intended that the embodiments and figures disclosed herein are to be considered illustrative rather than restrictive.
Figure 1 (PRIOR ART) shows a schematic diagram of a TFET;
Figure 2 illustrates a cross-section of the NW-TFET structure according to a preferred embodiment of the invention;
Figure 3 illustrates a front view of the NW-TFET structure according to a preferred embodiment of the invention;
Figure 4 illustrates a flow diagram of a preferred method for fabricating the NW-TFET of the present invention;
Figure 5A shows a typical energy band diagram of a TFET as shown in Figure 1 (prior art) without and with applied drain-source bias (no gate bias applied). The arrows indicate the tunnel barrier which needs to be crossed.
Figure 5B shows a typical energy band diagram of a TFET as shown in Figure 1 (prior art) without and with applied gate bias (no drain-source bias applied). The arrows indicate the tunnel barrier which needs to be crossed;
Figure 6A shows a TFET structure used for simulations. The structure is 2-dimensional and has a double-gate. The height of the central part (between the oxides) is 100 nm, and the height of the hafnium oxide is 4 nm. The width of the highly p-doped section is 65 nm, the barrier section is 3 nm, the width of the channel section is 100 nm, and the width of the highly n-doped section is 44 nm. The 3 nm barrier section is made of either Si, Si_{0.5}Ge_{0.5} or Ge;
Figure 6B illustrates the source-drain current I_{ds} as a function of gate voltage V_{gate} for the TFET structure as shown in Figure 6A with a Si barrier, a Si_{0.5}Ge_{0.5} barrier and a Ge barrier. The horizontal dashed lines indicate the target values for the off-current and the on-current for an LOP-design for node 14 (year 2020). The dashed line at an angle represents a 60 mV/dec slope, which is the best subthreshold slope which can be achieved with conventional MOSFETs. The voltage V_{ds} = 1 V for all curves.

### DETAILED DESCRIPTION OF ILLUSTRATIVE EMBODIMENTS

Embodiments of the present invention will be described with respect to particular embodiments and with reference to certain drawings but the invention is not limited thereto but only by the claims. The drawings described are only schematic and are non-limiting. In the drawings, the size of some of the elements may be exaggerated and not drawn to scale for illustrative purposes. The dimensions and the relative dimensions do not correspond to actual reductions to practice of the invention.

Furthermore, the terms first, second, third and the like in the description and in the claims, are used for distinguishing between similar elements and not necessarily for describing a sequential or chronological order. It is to be understood that the terms so used are interchangeable under appropriate circumstances and that the embodiments of the invention described herein are capable of operation in other sequences than described or illustrated herein.

Moreover, the terms top, bottom, over, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

Whenever reference is made hereinafter to a particular dopant type, this is done for the ease of explanation only and is not intended to limit the invention. It is to be understood that in the examples given herein below, materials and dopant types may be replaced by other suitable materials and dopant types, without changing the invention.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

The invention will now be described by a detailed description of several embodiments of the invention. It is clear that other embodiments of the invention can be configured according to the knowledge of persons skilled in the art without departing from the true spirit or technical teaching of the invention, the invention being limited only by the terms of the appended claims. In particular, some embodiments of the invention will be described with reference to nanowires, however, this is not intended to limit the invention, and is intended to encompass any example of an elongate nanostructure, which may include nanorods, nanowhiskers and other elongated substantially cylindrical or polygonal structures having a longitudinal axis.

At least some embodiments of the present invention are concerned with the problem of too low ON currents in existing tunnel field effect transistors (TFET). A heterosection is introduced, situated in between the channel region and the source (or drain) region of the TFET. Some embodiments of said TFET can be further characterized as a TFET whereby the source, drain and channel regions are fabricated in a nanowire made of a semiconducting material and the heterosection is further characterized as a section made of a material with a different lattice constant from the semiconductor material of the nanowire and whereby the heterosection is situated in between the channel region and the source (or drain) region in the nanowire. A heterosection is a section along the longitudinal axis of a nanowire which is made of a material which is different from the material of the main part of the nanowire. The use of a different material for the nanowire and the heterosection implies that the lattice constant will be different. As an example: if SiGe with a very small Ge content is used for the heterosection, then the lattice constant will be different from the lattice constant of pure Si used for the nanowire, but the difference will be very small, such that it can still be grown on top of Si without an excessive amount of dislocations. A TFET device whereby the channel region and the source/drain regions are fabricated in a nanowire is further referred to in this application as a NW-TFET.

At least some of the embodiments of the present invention relate to the creation of semiconductor devices and more specifically to the creation of a nanowire Tunnel-Field Effect Transistor (NW-TFET) on a semiconductor substrate. A NW-TFET structure is disclosed whereby the nanowire is made of a first semiconductor material and comprises a first source/drain section having a first doping level and first doping composition. The NW-TFET further comprises a second source/drain sections having a second doping level and second doping composition. Most preferred a p-doped section is situated at the one end of the nanowire and an n-doped section is situated in the other end of the nanowire. A heterosection made of a heterosection material can also be situated on the nanowire whereby the heterosection material is such that it has a different lattice constant from the first semiconductor material of the nanowire, and whereby the resulting NW-TFET has an improved performance compared to the TFET consisting of the semiconductor nanowire without a heterosection. This is because the subthreshold slope can be steeper, which allows to reduce the power supply and therefore the power consumption.

In a first embodiment of the invention, NW-TFETs using semiconducting nanowires are disclosed. TFETs using nanowires are known from the prior art (e.g. in US 2005/0274992) whereby said nanowire comprises a n-doped region and a p-doped region which is separated by an undoped channel region made of the same semiconducting material. However, none of the prior art devices includes a heterosection in between the source (or drain) region and the channel region whereby the heterosection is such that it has a different lattice constant than the semiconductor material of the nanowire. This can enable a performance improvement in that low ON currents (less than the International Technology Roadmap for Semiconductors ITRS roadmap predictions, which are currently predicting ON currents on the order of 1 mA/µm for a low power operating technology), a typical drawback related to the large resistance of the tunnel barrier in semiconductors with a bandgap of at least 1 eV (e.g. silicon), can be reduced or eliminated.

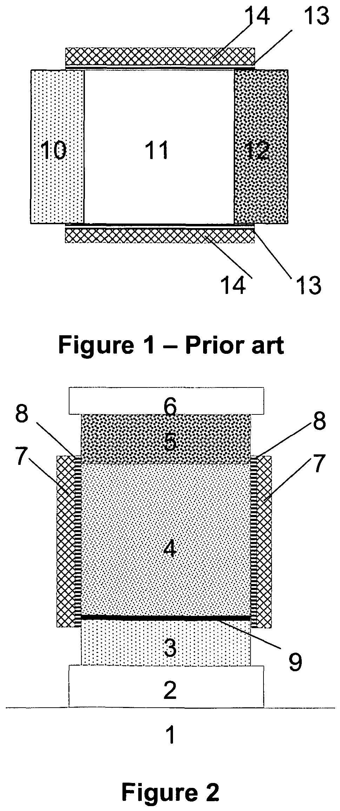

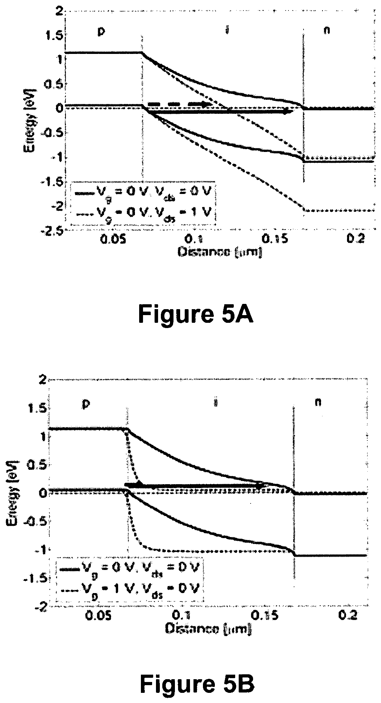

A traditional TFET (without having nanostructures) as shown in Figure 1 and described in the prior art is in fact a p-i-n diode, which is reverse biased and gated. The reverse bias turns the diode off. However, when a sufficiently large reverse bias is applied, quantum mechanical tunneling occurs of electrons from the valence band (in the p-doped section) to the conduction band (in the n-doped section), an effect usually called Zener breakdown. This is shown in Figure 5A, which displays the band diagram of an unbiased and a reverse biased p-i-n diode. The arrow in Figure 5A indicates the tunnel barrier which needs to be crossed. In a TFET, this tunnel effect is desired and represents the on-state of the transistor. The amount of current in the on-state is determined by the tunnel barrier width. The barrier width is the smallest when there is a highly doped region at either side of the tunnel barrier. This requires a highly doped source (or drain) section and a gate voltage such that a large carrier concentration is created in the intrinsic region next to the source (or drain) (see Figure 5B for the effect of a gate bias on the tunnel barrier width). The tunnel barrier width further decreases with decreasing band gap. When comparing this device with a MOSFET, there are a few differences, but many similarities. The MOSFET has either a p-doped source and drain (p-MOSFET) or an n-doped source and drain (n-MOSFET), whereas the TFET has a p-doped source and an n-doped drain, or vice versa. The channel, however, is lowly doped in both devices, and a gate voltage is applied to create a high-mobility channel. Therefore, if the resistance associated with the tunnel barrier can be made sufficiently small, the on-current of a TFET can in principle become comparable to the on-current of a MOSFET (usually the on-current of a TFET is, however, significantly smaller than the on-current of the corresponding MOSFET). The off-currents of a TFET are typically very small, which is due to the presence of the tunnel barrier. The conventional MOSFET on the other hand suffers from short-channel effects which results in source-drain leakage currents, especially as the device size scales down.

The NW-TFET of some embodiments of the present invention solves or mitigates the problem of low ON currents by introducing a small heterosection at the tunnel barrier of the channel, said heterosection is preferably made of a highly doped material which has preferably a smaller bandgap than the material used for source, drain and channel regions of the nanowire.

The NW-TFET of some embodiments of the invention can further be characterized as a TFET having at least one nanowire. Said nanowire comprises the source region, channel region and drain regions of the TFET device as well as the novel heterosection being situated at the tunnel barrier of the channel region. More specifically said heterosection can be situated in between the source region and the channel region of the nanowire. Alternatively said heterosection can be situated in between the drain region and the channel region of the nanowire.

The nanowire in the NW-TFET of some embodiments of the present invention can be characterized as a semiconducting nanowire wherein the diameter of the nanowire is between 1 and 500 nm and the length of the nanowire is between 5 nm and 2 µm. More preferred the diameter of the nanowire is between 2 nm and 200 nm and the length of the nanowire is between 10 nm and 1 µm.

The source region of the NW-TFET is made of a first semiconductor material which is highly p doped in case of a n-type NW-TFET, or alternatively in case of a p-type NW-TFET said source region is highly n doped. More preferred the doping level of the source region is in the range of 10¹⁸/cc to 10²¹/cc. Most preferred the doping level of the source region is in the range of 10¹⁹/cc to 5.10²⁰/cc. Said doping can be performed during the growth of the nanowire (e.g. by adding the appropriate doping gases during the growth) or after growth of the nanowire.

The drain region of the NW-TFET is made of a first semiconductor material which is highly n doped in case of a n-type NW-TFET, or alternatively in case of a p-type NW-TFET said source region is highly p doped. More preferred the doping level of the drain region is in the range of 10¹⁸/cc to 10²¹/cc. Most preferred the doping level of the drain region is in the range of 10¹⁹/cc to 5.10²⁰/cc. Said doping can be performed during the growth of the nanowire (e.g. by adding the appropriate doping gases during the growth) or after growth of the nanowire.

The channel region of the NW-TFET is also fabricated in the nanowire and is also made of a first semiconductor material. The channel region of the NW-TFET is situated in between the source and drain region. The doping level of the channel region is in the range of undoped up to 10¹⁶/cc doping. More preferred the doping level of the channel region is in the range of undoped up to 10¹⁴/cc doping. Said doping can be performed during the growth of the nanowire (e.g. by adding the appropriate doping gases during the growth) or after growth of the nanowire.

The first semiconductor material used to fabricate at least the source/drain region and channel region of the nanowire is selected from at least one of group IV materials such as Si, Ge, C and binary compounds thereof, or group III/V materials such as In, Ga, As, Sb, Al, P, B, N and binary, tertiary and quaternary compounds thereof or group II/VI materials such as Cd, Zn, S, Se, Te, O and binary, tertiary and quaternary compounds thereof. Most preferred said first semiconductor material is silicon.

The length of the channel region is preferably in the range of 1 nm to 1000 nm, more preferred in the range of 1 nm to 100 nm.

The heterosection is preferably made of a second semiconductor material whereby said second semiconductor material is such that it has a different lattice constant from the first semiconductor material of the nanowire. Said second semiconductor material is highly doped and is selected from at least one of the group IV materials such as Si, Ge, C and binary compounds thereof, or group III/V materials such as In, Ga, As, Sb, Al, P, B, N and binary, tertiary and quaternary compounds thereof or group II/VI materials such as Cd, Zn, S, Se, Te, O and binary, tertiary and quaternary compounds thereof. Most preferred said second semiconductor material is germanium or Si₁₋ₓGeₓ with x>0.5.

The doping level of the heterosection is preferably in the range of 10¹⁸/cc to 10²¹/cc, more preferred the doping level of the heterosection is in the range of 10¹⁹/cc to 5x10²⁰/cc. The doping level of the heterosection is preferably equal (or higher) than the doping level in source and drain regions of the NW-TFET.

Alternatively and also preferred, said heterosection can be made of metals (Al, W, Ta, Ti, Ru, Pd, Rh, Re, Pt, and alloys thereof), silicides, germanides, metal-nitrides such as TaN and TiN, conductive oxides such as RuO₂ and ReO₂, silicided metals such as CoSi₂, NiSi₂, metal germanides and alloys and mixtures thereof.

The length of the heterosection is preferably in the range of 1 nm up to 50 nm, more preferred the length of said heterosection is in the range of 2 nm up to 10 nm.

Onto the sidewalls of the nanowire, more specifically onto the sidewalls of the channel region of the nanowire, a gate structure is situated. Said gate structure can comprise a gate oxide (also referred to as gate dielectric) and a gate electrode (also referred to as gate contact). The gate oxide is making direct contact to the channel region of the nanowire; more specifically said gate oxide completely covers the outer sidewalls of the channel region. To ensure such a complete coverage, a small overlap of the gate oxide with the highly-doped drain and source region is desirable. Onto the gate oxide, a gate contact is deposited, said gate contact is thus situated on top of said gate oxide and is preferably covering the whole gate oxide. The gate structure, comprising gate oxide and gate contact, as described above can also be referred to as an all around gate structure.

The gate oxide is preferably selected from at least one of silicon based oxide (e.g. silicon dioxide, silicon oxy nitride) aluminium oxide, high-k oxides (oxides, nitrided oxides), silicates and nitrided silicates of transition metals such as Hf, Ta, Ti, Nb, V, Y, Zr. Most preferred said gate oxide is a high-k oxide such as hafnium oxide. The thickness of the gate oxide is preferably in the range of 0.5 nm to 20 nm.

The gate contact is preferably made of a conductive material and is preferably selected from at least one of poly silicon, poly germanium, metals such as Al, W, Ta, Ti, Ru, Pd, Rh, Re, Pt, and alloys thereof, metal-nitrides such as TaN and TiN, metal-silicon nitrides such as TaSiN, conductive oxides such as RuO₂ and ReO₃, fully silicided metals (FUSI) such as CoSi₂, NiSi and TiSi₂, fully germanided metals (FUGE), workfunction tunable metals, engineered materials to obtain a particular gate workfunction. Most preferred said gate contact is made of a metal of which the workfunction has been engineered specifically for the chosen nanowire material, the gate oxide material and gate oxide thickness (first and second semiconductor material) in order to get the desired threshold voltage of the T-FET.

The NW-TFET further comprises an electrical contact on each of the source region and drain region. Said electrical contact on each of the source region and drain region is a conductive material which is selected from at least one of a silicide containing structure (NiSi, CoSi₂, TiSi₂,...), a germanide containing structure, a metal containing structure, poly silicon or a combination thereof. Most preferred said electrical contact on each of the source region and drain region is a combination of a metal with a silicide.

In integrated circuits, the nanowire tunnel field effect transistor of the invention may be used as either an n-type transistor device or a p-type transistor device.

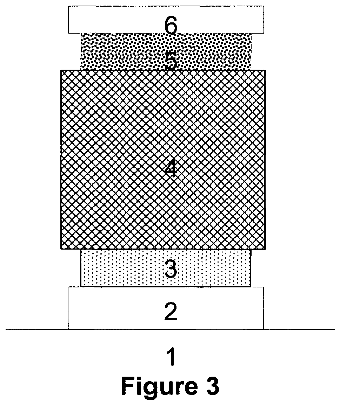

Figure 2 illustrates a cross-section of the NW-TFET structure according to a preferred embodiment of the invention and Figure **3** illustrates a front view of the NW-TFET structure according to a preferred embodiment of the invention.
In the example illustrated, the heterosection **9** does not extend out of the gate structure **7, 8.** Just like with a MOSFET, what has to be avoided, is that part of the undoped channel (= center) region **4** is not covered by the gate structure **7, 8.** The gate **7** will not have much effect on carrier density in the highly doped heterosection **9** (however, it will increase the capacitance with the source (or drain) region **3**). In the figures, the gate **7** is covering the heterosection **9,** but this is mainly because the heterosection **9** is very narrow. If the heterosection **9** is rather 50 nm as opposed to 3 nm, then the heterosection **9** will be partially outside of the gate structure **7, 8.**

In a second aspect of the invention, a method is provided for the fabrication of a nanowire Tunnel Field Effect transistor. Hereinafter, the method according to an embodiment of the invention will be illustrated for a device according to a preferred embodiment, i.e. for a n-type NW-TFET comprising at least one vertical nanowire as shown in Figure 2 (cross section) and Figure 3 (front view). It has to be understood that this is not limiting the invention and that the method may also be applied to create a p-type NW-TFET comprising at least one vertical nanowire.

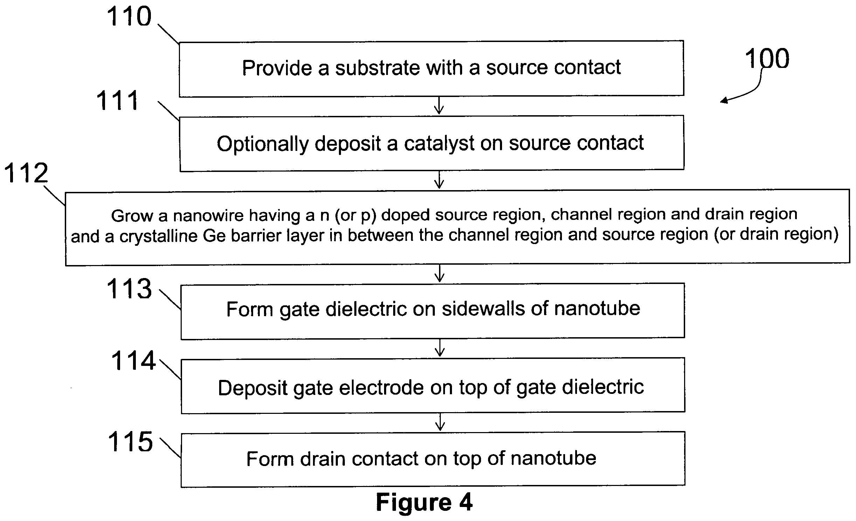

A preferred processing method is schematically illustrated in a flowchart 100 shown in Figure 4 and will be described in detail below. It has, however, to be understood that this is only an example of a suitable method for forming a device according to the invention and that the sequence of the process steps as described hereinafter is not limiting the invention.

In a first step **110,** a substrate **1** is provided. Preferably said substrate **1** is a semiconductor substrate such as a silicon substrate or a silicon on insulator (SOI) substrate but any other suitable substrate can be used as well such as, for example, glass, ceramics, etc. According to an embodiment of the invention, in said substrate **1** or alternatively on top of said substrate, a source contact **2** is created. The source contact **2,** may be made of a conductive material, e.g. said source contact **2,** may be a silicide containing structure (NiSi, CoSi₂, TiSi₂...), a germanide containing structure, a metal containing structure, polysilicon or a combination thereof. Also disclosed are source contacts **2,** formed of e.g. conductive oxides and even conductive polymers. In case the source contact **2** is a metal containing structure, all metals which form an ohmic contact with the material of a nanowire, or in other words all metals having a comparable work function with respect to the work function of the material of the nanowire, are preferred metals and may be used according to the invention. Preferably the source contact **2** is a silicide containing structure. The source contact **2,** can be the starting point for growing the nanowire and can, at the same time, act as the catalyst for the nanowire growth. However, the latter is not necessarily essential.

In case the source contact can not be used as a catalyst for the subsequent nanowire growth, a catalyst needs to be deposited onto the source contact, step **111.** Furthermore, the requirement of catalyst particles also depends on the technique used to form the nanowire.

In a next step **112,** a nanowire is grown, a preferred method is e.g. by means of a VLS (Vapor-Liquid-Solid) process, but also any other suitable technique known by a person skilled in the art may be used to form the nanowires according to the invention. For example, the nanowire may be grown using techniques such as, for example, CVD (Chemical Vapor Deposition), MOCVD (Metal Organic Chemical Vapor Deposition), or PECVD (plasma enhanced chemical vapor deposition) processes. Alternatively, also PLD (Pulsed Laser Deposition), ECD (Electrochemical Deposition), e-beam or MBE (Molecular Beam Epitaxy) processes may be used to grow the nanowires.

During growth of the nanowire, different regions with different doping levels and different doping types need to be created to form the source region **3,** the channel region **4,** the drain region **5** and the heterosection **9** of the nanowire. The different regions in the nanowire can be doped during the growth process to obtain a n-type or p-type region. Alternatively, the doping of the nanowire may be performed after growth of the nanowire by means of an additional doping step. The doping in one specific region, e.g. source region/ drain region is preferably uniform, but may also have a non-uniform doping profile.

During growth of the nanowire, first a source region **3** needs to be created. Said source region **3** is made of a first semiconductor material which is highly p doped in case of a n-type NW-TFET, or alternatively in case of a p-type NW-TFET said source region is highly n doped. More preferred the doping level of the source region is in the range of 10¹⁸/cc to 10²¹/cc. Most preferred the doping level of the source region is in the range of 10¹⁹/cc to 5.10²⁰/cc.

In a next step (to create a n-type NW-TFET as presented in Figure 2), a heterosection **9** is formed onto the source region **3.** The heterosection **9** is made of a second semiconductor material which is such that it has a different lattice constant compared to the first semiconductor material used to form the source region **3** of the nanowire. Said second semiconductor material is highly doped and is selected from at least one of the group IV materials such as Si, Ge, C and binary compounds thereof, or group III/V materials such as In, Ga, As, Sb, Al, P, B, N and binary, tertiary and quaternary compounds thereof or group II/VI materials such as Cd, Zn, S, Se, Te, O and binary, tertiary and quaternary compounds thereof. Most preferred said second semiconductor material is germanium or Si₁₋ₓGeₓ with x>0.5. The doping level of the heterosection is preferably in the range of 10¹⁸/cc to 10²¹/cc, more preferred the doping level of the heterosection is in the range of 10¹⁹/cc to 5x10²⁰/cc.

Alternatively and also preferred, said heterosection can be made of metals (Al, W, Ta, Ti, Ru, Pd, Rh, Re, Pt, and alloys thereof), silicides, germanides, metal-nitrides such as TaN and TiN, conductive oxides such as RuO₂ and ReO₂, silicided metals such as CoSi₂, NiSi₂, metal germanides and alloys and mixtures thereof.

Subsequently, the channel region of the NW-TFET is formed in the nanowire, said channel region is preferably made of the first semiconductor material, although other suitable/compatible materials can be used. The doping level of the channel region is in the range of undoped up to 10¹⁶/cc doping. More preferred the doping level of the channel region is in the range of undoped up to 10¹⁴/cc doping.

In a next step, a drain region **5** needs to be created on top of the channel region. Said drain region **5** is made of a first semiconductor material which is highly n doped in case of a n-type NW-TFET (or alternatively in case of a n-type NW-TFET said drain region **5** is highly p doped. More preferred the doping level of the drain region is in the range of 10¹⁸/cc to 10²¹/cc. Most preferred the doping level of the drain region is in the range of 10¹⁹/cc to 5.10²⁰/cc.

In a next step **113, 114,** a gate structure needs to be formed onto the sidewalls of the nanowire, more specifically onto the sidewalls of the channel region of the nanowire. Said gate structure comprises a gate oxide **8** (also referred to as gate dielectric) and a gate electrode **7** (also referred to as gate contact). First the gate oxide **8** is formed and deposited directly onto the channel region **4** of the nanowire **113.** Most preferred, said gate oxide **8** completely covers the outer sidewalls of the channel region **4.** To obtain a complete coverage of the channel region, a small overlap of the gate oxide with the highly-doped drain and source region is desirable. The gate oxide can be restricted to part of the nanowire (i.e. channel region), by means of a sacrificial layer, which is etched away before the oxide deposition (this implies that e.g. other materials are deposited onto the wafer after nanowire growth, such that the nanowire is embedded in other materials. This should be done in such a way that a sacrificial layer lines up with the channel region of the nanowire. After removal of the sacrificial material, a dielectric, e.g. an oxide, can be deposited onto the nanowire channel region.

Onto the gate dielectric, e.g. gate oxide, a gate contact (electrode) is deposited, step **114,** said gate contact is deposited on top of said gate dielectric, e.g. gate oxide, and is preferably covering the whole gate oxide.

The gate dielectric is preferably selected from at least one of silicon based oxide (e.g. silicon dioxide, silicon oxy nitride) aluminium oxide, high-k oxides (oxides, nitrided oxides), silicates and nitrided silicates of transition metals such as Hf, Ta, Ti, Nb, V, Y, Zr. Most preferred said gate oxide is a high-k oxide such as hafnium oxide. The thickness of the gate oxide is preferably in the range of 0.5 nm to 20 nm.
The gate contact is preferably made of a conductive material and is preferably selected from at least one of poly silicon, poly germanium, metals such as Al, W, Ta, Ti, Ru, Pd, Rh, Re, Pt, and alloys thereof, metal-nitrides such as TaN and TiN, metal-silicon nitrides such as TaSiN, conductive oxides such as RuO₂ and ReO₃, fully silicided metals (FUSI) such as CoSi₂, NiSi and TiSi₂, fully germanided metals (FUGE), workfunction tunable metals, engineered materials to obtain a particular gate workfunction. Most preferred said gate contact is made of a metal of which the workfunction has been engineered specifically for the chosen nanowire material, the gate oxide material and gate oxide thickness.

Finally **115** electrical contact is formed on the drain region (situated on top of the nanowire. Said electrical contact is preferably a conductive material which is selected from at least one of a silicide containing structure (NiSi, CoSi₂, TiSi₂,...), a germanide containing structure, a metal containing structure, poly silicon or a combination thereof. Most preferred said electrical contact is a combination of a metal with a silicide.

In case the nanowire is not doped during the growth process, an extra doping step may be advantageous. For example, implantation of dopant elements followed by activation of the dopant elements by e.g. annealing can be applied to achieve n-type or p-type region in the nanowire. Alternatively, a layer, which is also referred to as dopant layer and which comprises dopant elements can be deposited or a dopant metal can be selectively deposited, e.g. with electrochemical deposition, onto the nanowire regions (not shown). An anneal step may then be applied so as to incorporate the dopant into the nanowire region, resulting in an n-type or p-type region.

The whole processing sequence to obtain a NW-TFET, in the example shown in Figure 2 for a n-type NW-TFET, as described in the previous steps can be repeated to build a second NW-TFET structure on top of the existing NW-TFET structure starting on the drain contact. In case the first NW-TFET structure is a n-type NW-TFET structure, the second structure may preferably be a p-type NW-TFET structure.

### EXAMPLES

### Example 1: Simulations with device simulator MEDICI to determine the characteristics of a (silicon) NW-TFET with a highly-doped Ge section at the tunnel barrier.

TFETs typically suffer from low on-currents, a drawback related to the large resistance of the tunnel barrier. This simulation illustrated below demonstrates that high on-currents can be achieved for a TFET with a germanium (Ge) tunnel barrier in an otherwise silicon (Si) channel. Such a configuration is only possible when nanowires are used, such that the lattice mismatch between silicon and germanium does not result in a highly defective interface. The simulations predict a dynamic power reduction of up to a factor of at least 5, as well as a static power reduction of at least a factor of 2 compared to conventional MOSFET configurations. Multiple layers of logic can therefore be envisioned with these nanowire Si/Ge TFETs resulting in ultra-high on-chip transistor densities.

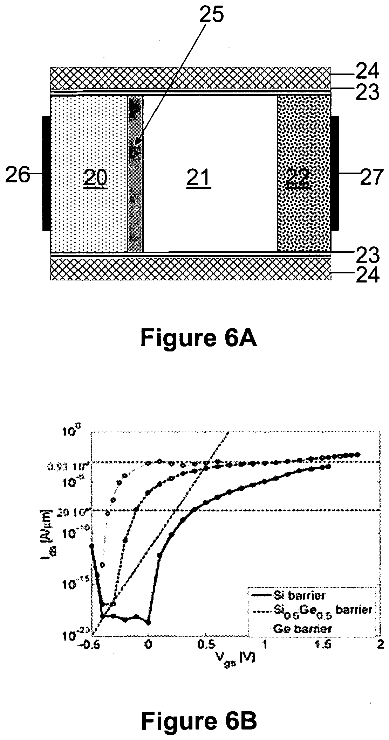

The simulations are performed with device simulator "MEDICI" to determine the characteristics of a (silicon) NW-TFET with a highly-doped Ge section at the tunnel barrier. The NW-TFET used for the simulation is shown in Figure 6A. The NW-TFET structure is 2-dimensional and has a double-gate. The height of the central part (between the oxides) is 100 nm, and the height of the hafnium oxide is 4 nm. The width of the highly p-doped section is 65 nm, the heterosection is 3 nm, the width of the channel region is 100 nm, and the width of the highly n-doped section is 44 nm. The 3 nm heterosection is made of either Si, Si_{0.5}Ge_{0.5} or Ge. The NW-TFET structure can be fabricated using the state of the art technology taking into account that nanowires can cope with the lattice mismatch between silicon and germanium. The most important dimensions in the NW-TFET structure to be taken into account for the electrical performance are the oxide thickness and the width of the channel region. Further parameters of importance are the doping of the source and drain sections, as well as the material used for the heterosection. The doping of the channel region is not critical, as long as it is lowly doped. The doping concentrations and dopant type in the NW-TFET used to perform the simulations are summarized in Table 1.

**Table 2: Doping concentrations and dopant type in the NW-TFET used to perform the simulations.**

| **Nanowire region** | **Dopant type/ concentration** | **Semiconductor material** |
|---|---|---|
| Source region | p-type, 10²⁰/cc | Si |
| Channel region | n-type, 10¹³/cc | Si |
| Heterosection | p-type, 10²⁰/cc | Ge |
| Drain region | n-type, 10²⁰/cc | Si |

The electrical characteristics of the NW-TFET structure as shown in Figure 6A are presented in Figure 6B. The source-drain current is the current underneath one of the double-gates only, to allow a fair comparison with a single-gate MOSFET structure. It can be observed that all devices can be turned off properly (see off-current requirements in Table 2). To achieve an on-current of 0.93 mA/µm (target for LOP, which is the most important design strategy, see Table 2) with the all-silicon NW-TFET would require very high gate voltages, as can be observed. However, for the NW-TFET with the Ge-section, such currents can be achieved at very low gate voltages.

**Table 2: International Technology Roadmap for Semiconductors (ITRS) roadmap values for node 14 (year 2020) of the on-current and off-current of a MOSFET for different design approaches.**

| **Design strategy** | **NMOS drive current** | **source-drain off-current** |
|---|---|---|
| Low operating power (LOP) | 0.930 mA/µm | 20 nA/µm |
| Low stand-by power (LSTP) | 1.3-1.4 mA/µm | 100-160 pA/µm |
| High performance (HP) | 3 mA/µm | 110 nA/µm |

The important figure of merit for the gate voltage is not the absolute gate voltage at which the required on-current is reached, but rather the difference between the gate voltage needed to turn the device off and the gate voltage needed to turn the device on. This is because gate work function engineering should allow to fabricate a gate material with a work function such that the device turns off at V_{gs} = 0 V (and therefore turns on at a gate voltage equal to the difference between the observed gate voltage of the on-state and the observed gate-voltage of the off-state). In the case of the structure with the Ge-section, this gate voltage switch is ΔV_{gs} = 0.45 V. For comparison, the maximum subthreshold slope of a MOSFET device is shown in Figure 6B, and it is clear that with such a subthreshold slope, a gate voltage swing of ΔV_{gs} = 0.45 V can never be achieved.

The smaller gate voltage swing allows to reduce the supply voltage (it has not been shown, but decreasing the voltage V_{ds} to 0.45 V is not expected to change the curves of Figure 6B, because the current is mainly determined by the width of the tunnel barrier and is not very dependent on V_{ds}, as long as V_{ds} doesn't get too small). This reduction in supply voltage in its turn reduces the power dissipation, both the static power (= I_{leakage} × V_{supply}) as well as the dynamic power (= C × f × V²_{supply}). With a planar conventional MOSFET design, it is questionable whether the supply voltage will ever be reduced below 1 V (due to the fixed subthreshold slope).

When a comparison is made with a MOSFET which operates at 1 V, it can be concluded that the dynamic power dissipation of the proposed Ge-barrier NW-TFET will be smaller by a factor of (1/0.45)² = 5, and that the static power dissipation will be smaller by at least a factor of 1/0.45 ≈ 2 (although we expect that a much smaller leakage power can be easily obtained if this is a priority by slight increasing the supply voltage: see Fig. 5 where it can be observed that the current I_{off} can be significantly reduced below the ITRS requirement). The proposed NW-TFET structure therefore fulfills the ITRS requirements of node 14 (year 2020) which cannot be achieved by a conventional MOSFET.

As has been described above, tunnel field-effect transistors (TFETs) are regarded as successors of metal-oxide semiconductor field-effect transistors (MOSFETs), but silicon-based TFETs typically suffer from low on-currents, a drawback related to the large resistance of the tunnel barrier. To achieve higher on-currents a TFET with a germanium (Ge) tunnel barrier in an otherwise silicon (Si) channel is used. A nanowire-based structure with a heterosection (9) is introduced such that the lattice mismatch between silicon and germanium does not result in a highly defective interface. A dynamic power reduction as well as a static power reduction can result, compared to conventional MOSFET configurations. Multiple layers of logic can therefore be envisioned with these nanowire Si/Ge TFETs resulting in ultra-high on-chip transistor densities.

## Claims

1. A Tunnel Field Effect Transistor (TFET) semiconductor device comprising at least one nanowire grown on a substrate (1) (NW-TFET), said nanowire comprising:
- a source region (2) made of a first semiconductor material which is highly doped according to a first conductivity type,
- a drain region (5) made of a first semiconductor material which is highly doped according to a second conductivity type,
- a channel region (4) made of a first semiconductor material having a doping level in the range of undoped up to 10¹⁶/cc according to the second conductivity type and which is situated in between the source and drain region, and
- a heterosection (9) made of a material having a different lattice constant from the first semiconductor material which is situated in between the source region or drain region and the channel region,
- on the channel region of the nanowire a gate structure, said gate structure comprising a gate dielectric (8) with on top of said gate dielectric a gate contact (7),
wherein the diameter of said at least one nanowire is between 1 and 500 nm.

2. The Tunnel Field Effect Transistor (NW-TFET) according to claim 1, wherein the gate structure covers completely the channel region of the nanowire.

3. The Tunnel Field Effect Transistor (NW-TFET) according to any of the previous claims further comprising an electrical contact (2,6) on each of the source region and drain region.

4. The Tunnel Field Effect Transistor (NW-TFET) according to any of the previous claims whereby said first semiconductor material is selected from at least one of group IV materials and binary compounds thereof, or group III/V materials and binary, tertiary and quaternary compounds thereof or group II/VI materials and binary, tertiary and quaternary compounds thereof.

5. The Tunnel Field Effect Transistor (NW-TFET) according to any of the previous claims whereby said first semiconductor material comprises silicon.

6. The Tunnel Field Effect Transistor (NW-TFET) according to any of the previous claims whereby said heterosection is made of a second semiconductor material which has a different lattice constant from the first semiconductor material of the nanowire.

7. The Tunnel Field Effect Transistor (NW-TFET) according to any of the previous claims whereby said second semiconductor material is selected from at least one of the group IV materials and binary compounds thereof, or group III/V materials and binary, tertiary and quaternary compounds thereof or group II/VI materials and binary, tertiary and quaternary compounds thereof.

8. The Tunnel Field Effect Transistor (NW-TFET) according to any of the previous claims whereby said second semiconductor material comprises germanium or Si₁₋ₓGeₓ with x>0.5.

9. The Tunnel Field Effect Transistor (NW-TFET) according to claims 1 to 5 whereby said heterosection is selected from at least one of the group of metals (Al, W, Ta, Ti, Ru, Pd, Rh, Re, Pt, and alloys thereof), silicides, germanides, metal-nitrides, conductive oxides, silicided metals , metal germanides and alloys and mixtures thereof.

10. The Tunnel Field Effect Transistor (NW-TFET) according to any of the previous claims, wherein the length of the at least one nanowire is between 5 nm and 2 µm, preferably between 10 nm and 1 µm.

11. The Tunnel Field Effect Transistor (NW-TFET) according to any of the previous claims whereby said gate dielectric is selected from at least one of silicon based oxide, aluminium oxide, high-k oxides, silicates and nitrided silicates of transition metals.

12. The Tunnel Field Effect Transistor (NW-TFET) according to claim 11 whereby said gate dielectric is hafnium oxide.

13. The Tunnel Field Effect Transistor (NW-TFET) according to any of the previous claims whereby said gate contact is made of a conductive material and is selected from at least one of poly silicon, poly germanium, a metal or a metal alloy, metal-nitrides, metal-silicon nitrides, conductive oxides, fully silicided metals, fully germanided metals, workfunction tunable metals, engineered materials to obtain a particular gate workfunction

14. The Tunnel Field Effect Transistor (NW-TFET) according to any of the previous claims whereby said gate contact is made of a metal of which the workfunction has been engineered specifically for the first and second semiconductor material, gate dielectric and gate dielectric thickness.

15. The Tunnel Field Effect Transistor (NW-TFET) according to any of the previous claims whereby said electrical contact on each of the source region and drain region is a conductive material which is selected from at least one of a silicide containing structure, a germanide containing structure, a metal containing structure, poly silicon or a combination thereof.

16. The Tunnel Field Effect Transistor (NW-TFET) according to any of the previous claims whereby said electrical contact on each of the source region and drain region is a combination of a metal with a silicide.

17. The Tunnel Field Effect Transistor (NW-TFET) according to any of the previous claims whereby the length of said heterosection is in the range of 1 nm up to 50 nm, preferably in the range of 2 nm to 10 nm.

18. The Tunnel Field Effect Transistor (NW-TFET) according to any of the previous claims whereby the length of said channel region is in the range of 1 nm to 1000 nm, preferably in the range of 1 nm to 100 nm.

19. The Tunnel Field Effect Transistor (NW-TFET) according to any of the previous claims whereby the thickness of the gate dielectric is in the range of 0.5 nm to 20 nm.

20. Tunnel Field Effect Transistor (NW-TFET) according to any of the previous claims whereby the doping level of the source region and drain region is in the range of 10¹⁸/cc to 10²¹/cc, preferably in the range of 10¹⁹/cc to 5x10²⁰/cc.

21. The Tunnel Field Effect Transistor (NW-TFET) according to any of the previous claims whereby the doping level of the heterosection is in the range of 10¹⁸/cc to 10²¹/cc, preferably in the range of 10¹⁹/cc to 5x10²⁰/cc.

22. The Tunnel Field Effect Transistor (NW-TFET) according to any of the previous claims whereby the doping level of the channel region is in the range of undoped up to 10¹⁴/cc doping.

23. A method for manufacturing a nanowire Tunnel Field Effect Transistor (NW-TFET) semiconductor device comprising the steps of :
- providing a substrate (1) lying in a plane,
- providing on said substrate (1) a source contact (2)
- growing a nanowire structure with a diameter of the at least one nanowire in between 1 and 500 nm, said nanowire having an integrated source region (3), a channel region (4) having a doping level in the range of undoped up to 10¹⁶/cc, a heterosection (9) and a drain region (5) whereby said source region, channel region and drain region are made of a first semiconductor material and the heterosection is made of a second material with a different lattice constant from the first semiconductor material,
- selectively doping said source region (3), channel region (4), heterosection (9) and drain region (5) to a desired doping level and dopant type,
- depositing on side walls of the nanowire structure a gate dielectric (8),
- depositing on top of the gate dielectric a gate contact (7),
- forming a drain contact (6) on top of the drain region of the nanowire.

24. The method of claim 23 whereby said substrate is a Si wafer.

25. The method of any of claims 23 or 24, whereby after providing on said substrate (1) a source contact (2) a catalyst is deposited.

26. Use of the method of any of claims 23 to 25 for forming a nanowire Tunnel Field Effect Transistor (NW-TFET) semiconductor device according to any of claims 1 to 22.

## Patentansprüche

1. Tunnel-Feldeffekttransistor (NW-TFET)-Halbleitervorrichtung, umfassend mindestens einen Nanodraht, der auf einem Substrat (1) gewachsen ist, wobei der Nanodraht Folgendes umfasst:
- einen Source-Bereich (2), der aus einem ersten Halbleitermaterial hergestellt ist, das gemäß einem ersten Leitfähigkeitstyp hochdotiert ist,
- einen Drain-Bereich (5), der aus einem ersten Halbleitermaterial hergestellt ist, das gemäß einem zweiten Leitfähigkeitstyp hochdotiert ist,
- einen Kanalbereich (4), der aus einem ersten Halbleitermaterial hergestellt ist, das einen Dotierungswert im Bereich von undotiert bis 10¹⁶/cc gemäß dem zweiten Leitfähigkeitstyp aufweist und das sich zwischen dem Source- und Drain-Bereich befindet, und
- einen Heteroabschnitt (9), der aus einem Material hergestellt ist, das eine andere Gitterkonstante als das erste Halbleitermaterial aufweist, die sich zwischen dem Source-Bereich oder Drain-Bereich und dem Kanalbereich befindet,
- auf dem Kanalbereich des Nanodrahtes, eine Gate-Struktur, wobei die Gate-Struktur ein Gate-Dielektrikum (8) mit einem Gate-Kontakt (7) auf der Oberseite des Gate-Dielektrikums umfasst,
wobei der Durchmesser des mindestens einen Nanodrahtes zwischen 1 und 500 nm beträgt.

2. Tunnel-Feldeffekttransistor (NW-TFET) nach Anspruch 1, wobei die Gate-Struktur den Kanalbereich des Nanodrahtes vollständig abdeckt.

3. Tunnel-Feldeffekttransistor (NW-TFET) nach einem der vorhergehenden Ansprüche, ferner umfassend einen elektrischen Kontakt (2, 6) jeweils auf dem Source-Bereich und dem Drain-Bereich.

4. Tunnel-Feldeffekttransistor (NW-TFET) nach einem der vorhergehenden Ansprüche, wobei das erste Halbleitermaterial ausgewählt wird aus mindestens einem von Gruppe IV-Materialien und binären Verbindungen davon oder Gruppe III/V-Materialien und binären, tertiären und quaternären Verbindungen davon oder Gruppe II/VI-Materialien und binären, tertiären und quaternären Verbindungen davon.

5. Tunnel-Feldeffekttransistor (NW-TFET) nach einem der vorhergehenden Ansprüche, wobei das erste Halbleitermaterial Silizium umfasst.

6. Tunnel-Feldeffekttransistor (NW-TFET) nach einem der vorhergehenden Ansprüche, wobei der Heteroabschnitt aus einem zweiten Halbleitermaterial hergestellt ist, das eine andere Gitterkonstante als das erste Halbleitermaterial des Nanodrahtes aufweist.

7. Tunnel-Feldeffekttransistor (NW-TFET) nach einem der vorhergehenden Ansprüche, wobei das zweite Halbleitermaterial ausgewählt wird aus mindestens einem von Gruppe IV-Materialien und binären Verbindungen davon oder Gruppe III/V-Materialien und binären, tertiären und quaternären Verbindungen davon oder Gruppe II/VI-Materialien und binären, tertiären und quaternären Verbindungen davon.

8. Tunnel-Feldeffekttransistor (NW-TFET) nach einem der vorhergehenden Ansprüche, wobei das zweite Halbleitermaterial Germanium oder Si₁₋ₓGeₓ mit x > 0,5 umfasst.

9. Tunnel-Feldeffekttransistor (NW-TFET) nach Anspruch 1 bis 5, wobei der Heteroabschnitt ausgewählt wird aus mindestens einem der Gruppe von Metallen (Al, W, Ta, Ti, Ru, Pd, Rh, Re, Pt und Legierungen davon), Siliciden, Germaniden, Metallnitriden, leitfähigen Oxiden, Metallsiliciden, Metallgermaniden und Legierungen und Gemischen davon.

10. Tunnel-Feldeffekttransistor (NW-TFET) nach einem der vorhergehenden Ansprüche, wobei die Länge des mindestens einen Nanodrahtes zwischen 5 nm und 2 µm beträgt, vorzugsweise zwischen 10 nm und 1 µm.

11. Tunnel-Feldeffekttransistor (NW-TFET) nach einem der vorhergehenden Ansprüche, wobei das Gate-Dielektrikum ausgewählt wird aus mindestens einem eines siliziumbasierten Oxids, Aluminiumoxids, High-k-Oxiden, Silikaten und nitrierten Silikaten von Übergangsmetallen.

12. Tunnel-Feldeffekttransistor (NW-TFET) nach Anspruch 11, wobei das Gate-Dielektrikum Hafniumoxid ist.

13. Tunnel-Feldeffekttransistor (NW-TFET) nach einem der vorhergehenden Ansprüche, wobei der Gate-Kontakt aus einem leitfähigen Material hergestellt ist und ausgewählt wird aus mindestens einem aus Polysilizium, Polygermanium, einem Metall oder einer Metalllegierung, Metallnitriden, Metall-Siliziumnitriden, leitfähigen Oxiden, Voll-Metallsiliciden, Voll-Metallgermaniden, Metallen mit abstimmbarer Austrittsarbeit, technischen Materialien, um eine spezielle Gate-Austrittsarbeit zu erhalten.

14. Tunnel-Feldeffekttransistor (NW-TFET) nach einem der vorhergehenden Ansprüche, wobei der Gate-Kontakt aus einem Metall hergestellt ist, dessen Austrittsarbeit für das erste und zweite Halbleitermaterial, das Gate-Dielektrikum und die Gate-Dielektrikum-Dicke eigens entwickelt wurde.

15. Tunnel-Feldeffekttransistor (NW-TFET) nach einem der vorhergehenden Ansprüche, wobei der elektrische Kontakt auf jeweils dem Source-Bereich und dem Drain-Bereich ein leitfähiges Material ist, das ausgewählt wird aus mindestens einem von Silicidhaltiger Struktur, Germanid-haltiger Struktur, metallhaltiger Struktur, Polysilizium oder einer Kombination davon.

16. Tunnel-Feldeffekttransistor (NW-TFET) nach einem der vorhergehenden Ansprüche, wobei der elektrische Kontakt auf jeweils dem Source-Bereich und dem Drain-Bereich eine Kombination aus einem Metall und einem Silicid ist.

17. Tunnel-Feldeffekttransistor (NW-TFET) nach einem der vorhergehenden Ansprüche, wobei die Länge des Heteroabschnitts im Bereich von 1 nm bis 50 nm liegt, vorzugsweise im Bereich von 2 nm bis 10 nm.

18. Tunnel-Feldeffekttransistor (NW-TFET) nach einem der vorhergehenden Ansprüche, wobei die Länge des Kanalbereichs im Bereich von 1 nm bis 1000 nm liegt, vorzugsweise im Bereich von 1 nm bis 100 nm.

19. Tunnel-Feldeffekttransistor (NW-TFET) nach einem der vorhergehenden Ansprüche, wobei die Dicke des Gate-Dielektrikums im Bereich von 0,5 nm bis 20 nm liegt.

20. Tunnel-Feldeffekttransistor (NW-TFET) nach einem der vorhergehenden Ansprüche, wobei der Dotierungswert des Source-Bereichs und Drain-Bereichs im Bereich von 10¹⁸/cc bis 10²¹/cc liegt, vorzugsweise im Bereich von 10¹⁹/cc bis 5x10²⁰/cc.

21. Tunnel-Feldeffekttransistor (NW-TFET) nach einem der vorhergehenden Ansprüche, wobei der Dotierungswert des Heteroabschnitts im Bereich von 10¹⁸/cc bis 10²¹/cc liegt, vorzugsweise im Bereich von 10¹⁹/cc bis 5x10²⁰/cc.

22. Tunnel-Feldeffekttransistor (NW-TFET) nach einem der vorhergehenden Ansprüche, wobei der Dotierungswert des Kanalbereichs im Bereich von undotiert bis 10¹⁴/cc Dotierung liegt.

23. Verfahren zur Herstellung einer Nanodraht-Tunnel-Feldeffekttransistor (NW-TFET)-Halbleitervorrichtung, umfassend folgende Schritte:
- Bereitstellen eines Substrats (1), das in einer Ebene liegt,
- Bereitstellen eines Source-Kontakts (2) auf dem Substrat (1),
- Wachsen einer Nanodraht-Struktur mit einem Durchmesser des mindestens einen Nanodrahtes von 1 bis 500 nm, wobei der Nanodraht einen integrierten Source-Bereich (3), einen Kanalbereich (4) mit einem Dotierungswert im Bereich von undotiert bis 10¹⁶/cc, einen Heteroabschnitt (9) und einen Drain-Bereich (5) aufweist, wobei der Source-Bereich, der Kanalbereich und der Drain-Bereich aus einem ersten Halbleitermaterial hergestellt sind und der Heteroabschnitt aus einem zweiten Material hergestellt ist, mit einer anderen Gitterkonstante als das erste Halbleitermaterial,
- wahlweises Dotieren des Source-Bereichs (3), des Kanalbereichs (4), des Heteroabschnitts (9) und des Drain-Bereichs (5) auf einen gewünschten Dotierungswert und Dotierungstyp,
- Aufbringen eines Gate-Dielektrikums (8) auf Seitenwänden der Nanodrahtstruktur,
- Aufbringen eines Gate-Kontakts (7) auf der Oberseite des Gate-Dielektrikums,
- Bilden eines Drain-Kontakts (6) auf der Oberseite des Drain-Bereichs des Nanodrahtes.

24. Verfahren nach Anspruch 23, wobei das Substrat ein Si-Wafer ist.

25. Verfahren nach einem der Ansprüche 23 oder 24, wobei nach dem Bereitstellen eines Source-Kontakts (2) auf dem Substrat (1) ein Katalysator aufgebracht wird.

26. Anwendung des Verfahrens nach einem der Ansprüche 23 bis 25 zur Bildung einer Nanodraht-Tunnel-Feldeffekttransistor (NW-TFET)-Halbleitervorrichtung nach einem der Ansprüche 1 bis 22.

## Revendications

1. Dispositif semi-conducteur à transistor à effet de champ tunnel (TFET) comprenant au moins un nanofil mis à croître sur un substrat (1) (NW-TFET), ledit nanofil comprenant :
- une région de source (2) faite d'un premier matériau semi-conducteur qui est hautement dopé selon un premier type de conductivité,
- une région de drain (5) faite d'un premier matériau semi-conducteur qui est hautement dopé selon un second type de conductivité,
- une région de canal (4) faite d'un premier matériau semi-conducteur ayant un niveau de dopage dans la plage allant de non dopé jusqu'à 10¹⁶/cm³ selon le second type de conductivité et qui est située entre les régions de source et de drain, et
- une hétérosection (9) faite d'un matériau ayant une constante de maille cristalline différente du premier matériau semi-conducteur qui est située entre la région de source ou la région de drain et la région de canal,
- sur la région de canal du nanofil, une structure de grille, ladite structure de grille comprenant un diélectrique de grille (8) avec au sommet dudit diélectrique de grille, un contact de grille (7),
dans lequel le diamètre dudit au moins un nanofil est compris entre 1 et 500 nm.

2. Transistor à effet de champ tunnel (NW-TFET) selon la revendication 1, dans lequel la structure de grille couvre complètement la région de canal du nanofil.

3. Transistor à effet de champ tunnel (NW-TFET) selon l'une quelconque des revendications précédentes, comprenant un contact électrique (2, 6) sur chacune de la région de source et de la région de drain.

4. Transistor à effet de champ tunnel (NW-TFET) selon l'une quelconque des revendications précédentes, dans lequel ledit premier matériau semi-conducteur est choisi parmi au moins l'un des matériaux du groupe IV et de leurs composés binaires, ou des matériaux du groupe III/V et de leurs composés binaires, tertiaires et quaternaires, ou des matériaux du groupe II/VI et de leurs composés binaires, tertiaires et quaternaires.

5. Transistor à effet de champ tunnel (NW-TFET) selon l'une quelconque des revendications précédentes, dans lequel ledit premier matériau semi-conducteur comprend du silicium.

6. Transistor à effet de champ tunnel (NW-TFET) selon l'une quelconque des revendications précédentes, dans lequel ladite hétérosection est faite d'un second matériau semi-conducteur qui a une constante de maille cristalline différente du premier matériau semi-conducteur du nanofil.

7. Transistor à effet de champ tunnel (NW-TFET) selon l'une quelconque des revendications précédentes, dans lequel ledit second matériau semi-conducteur est choisi parmi au moins l'un des matériaux du groupe IV et de leurs composés binaires, ou des matériaux du groupe III/V et de leurs composés binaires, tertiaires, et quaternaires, ou des matériaux du groupe II/VI et de leurs composés binaires, tertiaires, et quaternaires.

8. Transistor à effet de champ tunnel (NW-TFET) selon l'une quelconque des revendications précédentes, dans lequel ledit second matériau semi-conducteur comprend du germanium ou Si₁₋ₓGeₓ avec x > 0,5.

9. Transistor à effet de champ tunnel (NW-TFET) selon les revendications 1 à 5, dans lequel ladite hétérosection est choisie parmi au moins l'un du groupe des métaux (Al, W, Ta, Ti, Ru, Pd, Rh, Re, Pt, et leurs alliages), les siliciures, les germaniures, les nitrures de métal, les oxydes conducteurs, les métaux siliciurés, les germaniures de métal et leurs alliages et mélanges.

10. Transistor à effet de champ tunnel (NW-TFET) selon l'une quelconque des revendications précédentes, dans lequel la longueur de l'au moins un nanofil est comprise entre 5 nm et 2 µm, de préférence entre 10 nm et 1 µm.

11. Transistor à effet de champ tunnel (NW-TFET) selon l'une quelconque des revendications précédentes, dans lequel ledit diélectrique de grille est choisi parmi au moins l'un d'un oxyde à base de silicium, de l'oxyde d'aluminium, d'oxydes à k élevée, de silicates et de silicates nitrurés de métaux de transition.

12. Transistor à effet de champ tunnel (NW-TFET) selon la revendication 11, dans lequel ledit diélectrique de grille est de l'oxyde d'hafnium.

13. Transistor à effet de champ tunnel (NW-TFET) selon l'une quelconque des revendications précédentes, dans lequel ledit contact de grille est fait d'un matériau conducteur et est choisi parmi au moins l'un du polysilicium, du polygermanium, d'un métal ou d'un alliage de métal, de nitrures de métaux, de nitrures de métal-silicium, d'oxydes conducteurs, de métaux totalement siliciurés, de métaux totalement germaniurés, de métaux à travail d'extraction ajustable, de matériaux d'ingénierie pour obtenir une fonction d'extraction de grille particulière.

14. Transistor à effet de champ tunnel (NW-TFET) selon l'une quelconque des revendications précédentes, dans lequel ledit contact de grille est fait d'un métal dont la fonction d'extraction a été mise au point spécifiquement pour le premier et le second matériau semi-conducteur, le diélectrique de grille et l'épaisseur du diélectrique de grille.

15. Transistor à effet de champ tunnel (NW-TFET) selon l'une quelconque des revendications précédentes, dans lequel ledit contact électrique sur chacune de la région de source et de la région de drain est un matériau conducteur qui est choisi parmi au moins l'une parmi une structure contenant du siliciure, une structure contenant du germaniure, une structure contenant du métal, du polysilicium ou l'une de leurs combinaisons.

16. Transistor à effet de champ tunnel (NW-TFET) selon l'une quelconque des revendications précédentes, dans lequel ledit contact électrique sur chacune de la région de source et de la région de drain est une combinaison d'un métal avec un siliciure.

17. Transistor à effet de champ tunnel (NW-TFET) selon l'une quelconque des revendications précédentes, dans lequel la longueur de ladite hétérosection est dans la plage de 1 nm jusqu'à 50 nm, de préférence dans la plage de 2 nm à 10 nm.

18. Transistor à effet de champ tunnel (NW-TFET) selon l'une quelconque des revendications précédentes, dans lequel la longueur de ladite région de canal est dans la plage de 1 nm à 1 000 nm, de préférence dans la plage de 1 nm à 100 nm.

19. Transistor à effet de champ tunnel (NW-TFET) selon l'une quelconque des revendications précédentes, dans lequel l'épaisseur du diélectrique de grille est dans la plage de 0,5 nm à 20 nm.

20. Transistor à effet de champ tunnel (NW-TFET) selon l'une quelconque des revendications précédentes, dans lequel le niveau de dopage de la région de source et de la région de drain est dans la plage de 10¹⁸/cm³ à 10²¹/cm³, de préférence dans la plage de 10¹⁹/cm³ à 5 x 10²⁰/cm³.

21. Transistor à effet de champ tunnel (NW-TFET) selon l'une quelconque des revendications précédentes, dans lequel le niveau de dopage de l'hétérosection est dans la plage de 10¹⁸/cm³ à 10²¹/cm³, de préférence dans la plage de 10¹⁹/cm³ à 5 x 10²⁰/cm³.

22. Transistor à effet de champ tunnel (NW-TFET) selon l'une quelconque des revendications précédentes, dans lequel le niveau de dopage de la région de canal est dans la plage allant de non dopé jusqu'à 10¹⁴/cm³ de dopage.

23. Procédé de fabrication d'un dispositif semi-conducteur à transistor à effet de champ tunnel à nanofil (NW-TFET) comprenant les étapes de :
- fourniture d'un substrat (1) reposant dans un plan,
- fourniture d'un contact de source (2) sur ledit substrat (1),
- croissance d'une structure de nanofil avec un diamètre de l'au moins un nanofil entre 1 et 500 nm, ledit nanofil ayant une région de source intégrée (3), une région de canal (4) ayant un niveau de dopage dans la plage allant de non dopé jusqu'à 10¹⁶/cm³, une hétérosection (9) et une région de drain (5), dans lequel lesdites région de source, région de canal et région de drain sont faites d'un premier matériau semi-conducteur et l'hétérosection est faite d'un second matériau avec une constante de maille cristalline différente du premier matériau semi-conducteur,
- dopage sélectif desdites région de source (3), région de canal (4), hétérosection (9) et région de drain (5) à un niveau de dopage et un type de dopant souhaités,
- dépôt sur des parois latérales de la structure de nanofil d'un diélectrique de grille (8),
- dépôt au sommet du diélectrique de grille d'un contact de grille (7),
- formation d'un contact de drain (6) au sommet de la région de drain du nanofil.

24. Procédé selon la revendication 23, dans lequel ledit substrat est une tranche de Si.

25. Procédé selon l'une quelconque des revendications 23 ou 24, dans lequel après fourniture sur ledit substrat (1) d'un contact de source (2), un catalyseur est déposé.

26. Utilisation du procédé de l'une quelconque des revendications 23 à 25, pour former un dispositif semi-conducteur à transistor à effet de champ tunnel à nanofil (NW-TFET) selon l'une quelconque des revendications 1 à 22.
